Europäisches Patentamt

European Patent Office

Office européen des brevets

(11) Publication number: **0 077 930**
**B1**

# (12) EUROPEAN PATENT SPECIFICATION

(45) Date of publication of patent specification: **06.05.87**

(51) Int. Cl.⁴: **H 01 L 29/743**, H 01 L 29/60

(21) Application number: **82108973.7**

(22) Date of filing: **28.09.82**

(54) **Gate turn-off thyristor.**

(30) Priority: **23.10.81 JP 169889/81**

(43) Date of publication of application:
**04.05.83 Bulletin 83/18**

(45) Publication of the grant of the patent:
**06.05.87 Bulletin 87/19**

(84) Designated Contracting States:
**DE SE**

(56) References cited:
**EP-A-0 014 098**
**EP-A-0 022 355**
**FR-A-2 377 095**
**US-A-3 611 072**
**US-A-4 127 863**

(73) Proprietor: **Kabushiki Kaisha Toshiba**
**72, Horikawa-cho Saiwai-ku**
**Kawasaki-shi Kanagawa-ken 210 (JP)**

(72) Inventor: **Takigami, Katsuhiko**
**3429-6, Akuwa-cho Seya-ku**
**Yokohama-shi (JP)**
Inventor: **Azuma, Makoto**
**205 Nakakibogaoka Asahi-ku**
**Yokohama-shi (JP)**

(74) Representative: **Lehn, Werner, Dipl.-Ing. et al**
**Hoffmann, Eitle & Partner Patentanwälte**
**Arabellastrasse 4 (Sternhaus)**
**D-8000 München 81 (DE)**

Courier Press, Leamington Spa, England.

## Description

The present invention relates to a gate turn-off thyristor and, more particularly, to a gate turn-off thyristor with a reduced gate turn-off loss, comprising a first emitter layer of a first conductivity type, a first base layer of a second conductivity type formed on said first emitter layer, a second base layer of the first conductivity type formed on said first base layer, a plurality of second emitter layers of the second conductivity type formed on said second base layer, a plurality of cathode electrodes formed on said second emitter layers, a gate electrode disposed on said second base layer so as to surround said second emitter layers and said cathode layers, and an anode electrode formed on said first emitter layer of the first conductivity type.

In the gate turn-off thyristor (to be referred to as a GTO thyristor for brevity hereinafter), when a positive voltage is applied across the anode and the cathode of the thyristor, if a positive potential is applied to the gate thereof to cause a gate current to flow, then the anode-cathode path is conductive to allow an anode current to flow therethrough. When the anode current flows in the thyristor, if a negative potential is applied to the gate electrode, the anode current is pulled out of the gate electrode, so that the thyristor is turned off. Time required for the GTO thyristor to be switched from an ON state to an OFF state, that is, a gate-turn-off time, limits service frequencies of apparatuses using GTO thyristors. For this reason, the gate turn-off time is one of the important electric properties of GTO thyristors.

With a recent trend toward an increased power capacity of the GTO thyristor, diameter and thickness of the silicon wafer used for the GTO thyristor increase, resulting in elongation of the gate turn-off time of the thyristor. This is undesirable for high frequency applications.

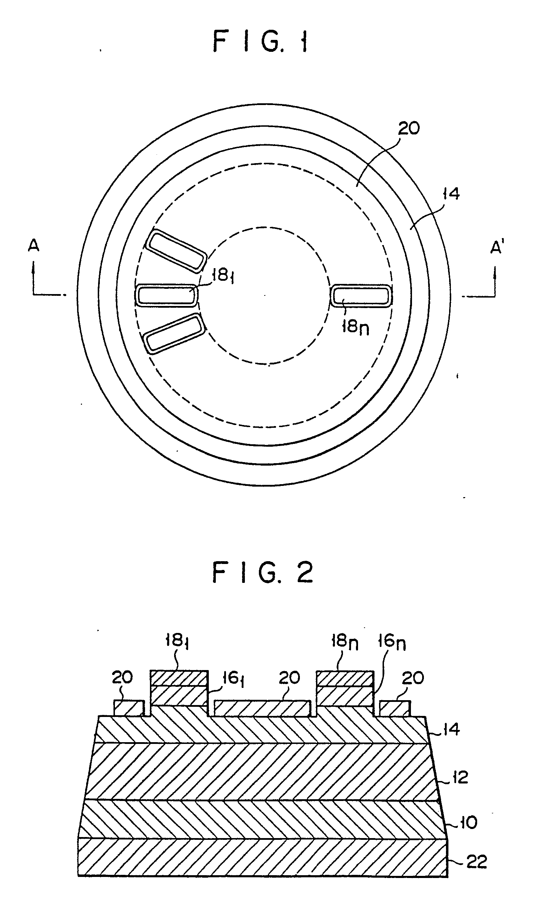

Fig. 1 is a plan view of a prior GTO thyristor as viewed from the cathode electrode side and Fig. 2 shows a cross section taken on line A—A' in Fig. 1.

The GTO thyristor contains four continuous layers, a p-type first emitter layer 10, an n-type first base layer 12, p-type second base layer 14, and an n-type second emitter layer 16 ($16_1$ to 16n). The second emitter layer 16 is divided into a plurality of layers (n layers, for example). Cathode electrodes $18_1$ to 18n are provided on the second emitter layers $16_1$ to 16n, respectively. The gate electrode 20 is formed on the second base layer 14, so as to surround the cathode area. An anode electrode 22 made of tungsten, for example, is provided on the first emitter layer 10. Two circles as indicated by dotted lines schematically indicate that the cathode electrodes $18_1$ to 18n are arranged circularly.

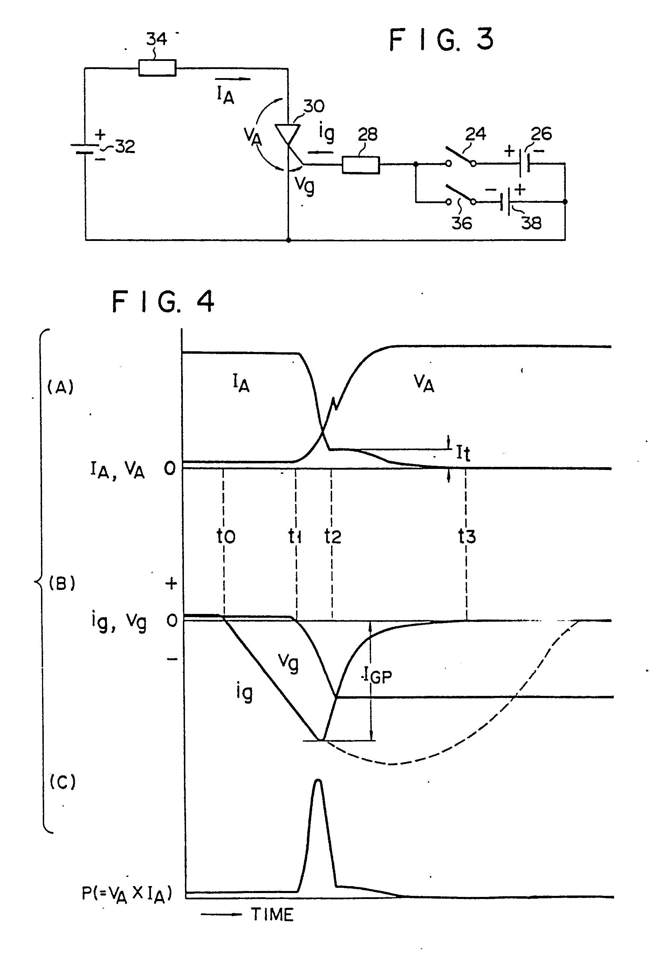

Fig. 3 is a circuit diagram for explaining the operation of the GTO thyristor. When the switch 24 in an on-gate circuit is turned on, a closed circuit consisting of an on-gate power source 26, a switch 24, a circuit impedance 28 and a GTO thyristor 30 has an on-gate current circulating therein. The GTO thyristor 30 is triggered by the on-gate current and rendered conductive. The result is that a main current flows in a closed circuit consisting of a main power source 32, a load 34, and the GTO thyristor 30, in other words, the anode current IA of the GTO thyristor 30.

In order to gate turn off the GTO thyristor 30 when it is in a turn-on state, the switch 36 of an off-gate circuit is turned on. Then, a gate current $i_g$ having a direction opposite to that occurring when the GTO thyristor is gate turned on, flows in a closed circuit consisting of an off-gate power source 38, the switch 36, the circuit impedance 28, and the GTO thyristor 30. The gate current $i_g$ turns off the GTO thyristor 30.

Figs. 4A, 4B and 4C show waveforms for explaining the operation of the GTO thyristor 30 when it is gate turned off.

When the GTO thyristor 30 is conductive, if the gate turn-off switch 36 is closed at time t0, the off-gate current $i_g$ increases toward the negative (Fig. 4B). At time t1, the anode current IA starts to decrease and at the same time the voltage VA across the anode and the cathode also starts to increase (Fig. 4A).

At time t2, the junction between the gate and the cathode is restored, and the gate-cathode voltage $v_g$ reaches a negative maximum. The gate current $i_g$ reaches a negative maximum before the gate-cathode voltage $v_g$ reaches the negative peak value, and the gate current $i_g$ then sharply reduces toward the positive (Fig. 4B).

At time t2, the anode current IA has a current value based on the residual charge in the GTO thyristor. The current with an initial value It and flowing after time t2 is called a tail current (Fig. 4A).

In the GTO thyristor operation as mentioned above, a turn-off time $t_{off}$ is a time period from t0 to t2 ($t_{off}=t2-t0$). The anode current IA flowing after time t2 continues to flow until time t3 when the stored charge in the GTO thyristor disappears (Fig. 4A).

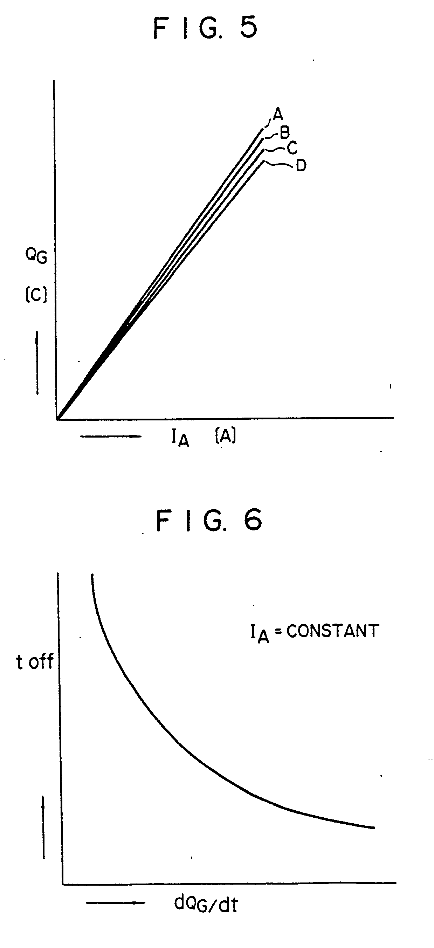

In Fig. 4B, when the voltage $E_G$ of the off-gate power source 38 is lower than the gate-cathode reverse breakdown voltage $V_{J1}$ of the GTO thyristor ($E_G<V_{J1}$), the gate current $i_g$ reaches its negative peak $I_{GP}$ and decreases as indicated by a solid line. On the other hand, when the voltage $E_G$ of the off-gate power source 38 is larger than the gate-cathode breakdown voltage $V_{J1}$ ($E_G>V_{J1}$), the gate current $i_g$ further increases toward the negative and then decreases as indicated by a broken line. Fig. 4C illustrates a power loss P($=VA\times IA$) at the time of the gate turning off. Fig. 5 illustrates a relationship between the anode current IA and an off-gate charge amount

$$Q_G(=\int_{t0}^{t2} -i_g dt).$$

In the graph of Fig. 5, the same relationship is illustrated with parameters A to D of an off-gate

current rising rate (di$_g$/dt). The parameters are in the order of A<B<C<D. As shown Q$_G$ changes linearly with respect to IA and this is little influenced by the off-gate current rising rate (di$_g$/dt). This implies that to turn off an anode current, a substantially constant off-gate charge quantity Q$_G$ is required irrespective of the rising rate of the off-gate current.

Fig. 6 shows a relationship of the turn-off time t$_{off}$ with respect to an off-gate charge quantity discharged per unit time when the anode current is constant. As seen from the graph, to shorten the turn-off time t$_{off}$, the off-gate charge quantity Q$_G$ discharged per unit time must be increased.

The circuit impedance 28 in the off-gate circuit has only a negligible amount of DC resistance, and a rising rate di$_g$/dt ($\fallingdotseq$E$_G$/L) of the off-gate current is determined by the inductance L. Therefore, the off-gate charge Q$_G$ is given approximately as:

$$Q_G = 1/2 \cdot E_G/L \cdot (t_{off})^2 \qquad (1)$$

Accordingly, to make the Q$_G$ larger while the gate turn-off time t$_{off}$ is kept small, there is no other way than increasing the voltage E$_G$ if the inductance L is a minimum value usually obtained. As indicated by a broken line in Fig. 4B, if the off-gate power source voltage E$_G$ is larger than the gate-cathode reverse breakdown voltage V$_{J1}$ of the GTO thyristor (V$_{J1}$<E$_G$), a Zener current flows, causing power loss as given by the product of the Zener current and the gate-cathode voltage restored up to V$_{J1}$. The heat generated remarkably reduces the reliability of the GTO thyristor.

For the purpose of shortening the turn-off time, heavy metal is doped into the wafer, or the first base layer and the first emitter are exposed at one main surface and shortened by the anode electrode. These measures, however, bring about increasing both the forward voltage drop and the latching current.

A gate turn-off thyristor of said type is disclosed in EP—A1—0 022 355.

In EP—A2—0 014 098 a gate turn-off thyristor is disclosed that shows two separate gate electrodes. However, these two gate electrodes belong to two thyristors, one of which is a main thyristor, whereas the second one is an auxiliary thyristor. A control signal as applied to the gate electrode of the auxiliary thyristor, which has its cathode connected to the gate electrode of the main thyristor, produces an amplified control signal, which is applied to the gate electrode of the main thyristor, which in turn controls the output of said main thyristor at its cathode. Each of said thyristors has only one gate electrode. Said prior art gate turn-off thyristor needs two different sub-thyristors formed on a common substrate to reduce gate power losses.

Accordingly, an object of the present invention is to provide a gate turn-off thyristor with reduced power loss and to provide a gate turn-off thyristor which may shorten a gate turn-off time without increasing the latching current and the forward voltage drop.

To achieve this object, in the present invention, a plurality of separate gate electrodes with substantially the same areas are provided on the second base layer. Each of the gate electrodes surrounds at least one cathode electrode.

Particular embodiments of the invention are set out in the dependent claims.

With the plurality of the gate electrodes of the GTO thyristor, a current of Ik/m, which is obtained by dividing the cathode current Ik by the number of the gate electrodes m, flows as the cathode current into each cathode electrode surrounded by a corresponding gate electrode. This is equivalent to an arrangement of a plurality of smaller GTO thyristors each with a volume l/m of the original GTO thyristor connected in parallel.

Since the cathode current Ik is substantially equal to the anode current IA, if the current Ik becomes smaller, the off-gate charge Q$_G$ also becomes smaller, as seen from Fig. 5. Accordingly, the equation (1) shows that if the gate turn-off time t$_{off}$ is equal to that of the prior thyristor, the off-gate voltage E$_G$ may be smaller. Further, by making the voltage E$_G$ smaller, the tail current becomes smaller, so that the power loss P at the time of turn-off may be reduced. Further, with the smaller E$_G$, the Zener current flowing after the turn-off may be prevented, improving the reliability of the GTO thyristor.

Further, when the off-gate voltage E$_G$ is equal to that of the prior GTO thyristor, the gate turn-off time t$_{off}$ may be reduced, as seen from the equation (1).

By way of example and to make the description clearer, reference is made to the accompanying drawings, in which:

Fig. 1 shows a plan view of a prior GTO thyristor as seen from the cathode electrode side;

Fig. 2 shows a cross sectional view taken on line A—A' in Fig. 1;

Fig. 3 is a circuit diagram for explaining the operation of the circuit of Fig. 3;

Figs. 4A to 4C show waveforms for explaining the operation of the circuit shown in Fig. 3;

Fig. 5 shows a graph illustrating a relationship between an anode current IA and an off-gate charge quantity Q$_G$;

Fig. 6 shows a graph depicting a relationship between an off-gate charge quantity dQ$_G$/dt discharged per unit time and a turn-off time t$_{off}$;

Fig. 7 shows a plan view of a GTO thyristor as viewed from the cathode side according to an embodiment of the present invention; and

Fig. 8 shows a cross sectional view taken on line B—B' of the thyristor of Fig. 7.

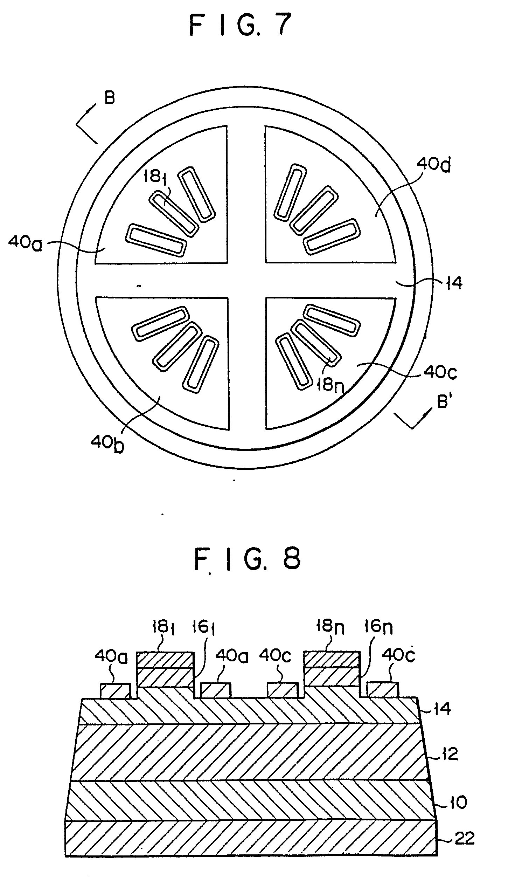

Fig. 7 shows a plan view of a GTO thyristor as viewed from the cathode side according to an embodiment of the present invention and Fig. 8 shows a cross sectional view taken on line B—B' in Fig. 7. In Figs. 7 and 8, like symbols are used for designating like portions in Figs. 1 and 2.

A different point of the GTO thyristor in the present embodiment from that of Figs. 1 and 2, resides in the provision of a plurality of gate electrodes. In this embodiment, the gate electrode 40 consists of four gate electrodes 40a, 40b, 40c and 40d. The number of the gate electrodes may properly be selected, for example, at more or less than 4. When *m* number of gate electrodes are used, the GTO thyristor is equivalent to *m* number of thyristors each having l/m volume of the GTO thyristor arranged in parallel.

When a turn-on pulse is applied to the gate electrodes 40a to 40d of the GTO thyristor at the same time, the GTO thyristor is conductive. The cathode current of each cathode electrode surrounded by the corresponding gate electrode 40a, 40b, 40c or 40d is 1/4 of the cathode current of the whole thyristor.

At the time of turning off, if all gate electrodes 40a to 40d are simultaneously applied with an off pulse, these gate electrodes 40a to 40d pull out current from the thyristor and the thyristor is turned off. The charge quantity pulled out by each of the gate electrodes is 1/4 of the whole current.

At this time, a rising rate of the off-gate current ($di_g/dt$) is approximately expressed by $di_g/dt=E_G/L$ for each gate electrode 40a to 40d where the gate power source voltage is $E_G$ and the total inductance of the gate circuit is L. An off-gate charge quantity $Q_G$ per gate is also given, like the equation (1),

$$Q_G=1/2 \cdot E_G/L \cdot (t_{off})^2.$$

In this embodiment, the $Q_G$ pulled out by each gate electrode is smaller than that of the prior GTO not with a plurality of gate electrodes.

Accordingly, when the same turn-off time $t_{off}$ as that of the prior GTO thyristor is employed, the $E_G$ may be smaller than the prior one. The reduced $E_G$ makes the tail current initial value It smaller, and the power loss $P=(VA\times IA)$ at the time of the gate turning off may also be reduced. The smaller $E_G$ may lessen a probability that the Zener current flows after the turn off. This improves the reliability of the GTO thyristor.

When the L and $E_G$ are the same as those of the prior-art, the $t_{off}$ may be made smaller. Therefore, unlike the prior art, there is no need for the heavy metal doping or the special structure. Therefore, the latching current and the forward voltage drop are never increased.

The GTO thyristor with such a structure may be realized by the same fabricating process steps as those of the prior art. Specifically, the cathode electrodes 18l to 18n shown in Figs. 7 and 8 and the gate electrodes 40a to 40d are formed in a manner such that soft metal, e.g., aluminum is uniformly deposited over the main surfaces of the cathode and the gate of the semiconductor, and unnecessary soft metal portions are etched away using a resist mask having gate electrode patterns. Therefore, no additional cost is required for reducing the invention to practice.

If the gate electrodes 40a to 40d are separated from one another by 100 μm or more, a sheet resistance of the second base layer 14 is normally several tens $\Omega/\square$, and hence the gate electrodes are electrically separated to a satisfactory extent, thus attaining the effect by this invention.

It is evident that the present invention is not limited to the above-mentioned embodiment any way. For example, the present invention is applicable for the GTO thyristor with a structure such that a part of the first base layer is exposed to the main surface of the anode surface and the first emitter layer and the first base layer are shorted by the anode electrode.

It should be understood that the present invention may be variously changed and modified within the scope of the present invention.

**Claims**

1. A gate turn-off thyristor comprising a first emitter layer (10) of a first conductivity type, a first base layer (12) of a second conductivity type formed on said first emitter layer (10), a second base layer (14) of the first conductivity type formed on said first base layer (12), a plurality of second emitter layers ($16_1$ to 16n) of the second conductivity type formed on said second base layer (14), a plurality of cathode electrodes ($18_1$ to 18n) formed on said second emitter layers ($16_1$ to 16n) a gate electrode disposed on said second base layer (14) so as to surround said second emitter layers ($16_1$ to 16n) and said cathode layers ($18_1$ to 18n), and an anode electrode (22) formed on said first emitter layer (10) of the first conductivity type, characterized in that said gate electrode is comprised of a plurality of separate electrodes (40a, 40b, 40c, 40d) with substantially the same areas, each of said separate electrodes (40a to 40d) surrounding at least one of said second emitter layers ($16_1$ to 16n) and the corresponding cathode electrode ($18_1$ to 18n).

2. A gate turn-off thyristor according to claim 1, characterized in that said plurality of separate electrodes (40a to 40d) are symmetrically arranged with respect to the center of said second base layer (14).

3. A gate turn-off thyristor according to claim 2, characterized in that each of said plurality of separate electrodes (40a to 40d) is sector-shaped.

**Patentansprüche**

1. Thyristor mit Löschsteuerung mit einer ersten Emitterschicht (10) eines ersten Leitfähigkeitstyps, einer ersten, auf der ersten Emitterschicht (10) gebildeten Basisschicht (12) eines zweiten Leitfähigkeitstyps, einer zweiten, auf der ersten Basisschicht (12) gebildeten Basisschicht (14) des ersten Leitfähigkeitstyps, einer Vielzahl von zweiten, auf der zweiten Basisschicht (14) gebildeten Emitterschichten ($16_1$ bis $16_n$) des zweiten Leitfähigkeitstyps, einer Vielzahl von auf den zweiten Emitterschichten ($16_1$ bis $16_n$) gebildeten Kathodenelektroden ($18_1$ bis $18_n$), einer auf der zweiten Basisschicht (14) derart angeordneten Gatterelektrode, daß sie die zweiten Emitterschichten ($16_1$ bis $16_n$) und die Kathoden-

schichten ($18_1$ bis $18_n$) umgibt, und einer auf der ersten Emitterschicht (10) des ersten Leitfähigkeitstyps gebildeten Anodenelektrode (22), dadurch gekennzeichnet, daß die Gatterelektrode aus einer Vielzahl von getrennten Elektroden (40a, 40b, 40c, 40d) mit im wesentlichen den gleichen Flächeninhalten besteht, wobei jede der getrennten Elektroden (40a bis 40d) mindestens eine der zweiten Emitterschichten ($16_1$ bis $16_n$) und die entsprechende Kathodenelektrode ($18_1$ bis $18_n$) umgibt.

2. Thyristor mit Löschsteuerung nach Anspruch 1, dadurch gekennzeichnet, daß die Vielzahl von getrennten Elektroden (40a bis 40d) in Bezug auf die Mitte der zweiten Basisschicht (14) symmetrisch angeordnet sind.

3. Thyristor mit Löschsteuerung nach Anspruch 2, dadurch gekennzeichnet, daß jede der Vielzahl der getrennten Elektroden (40a bis 40d) sektorförmig ist.

**Revendications**

1. Thyristor à grille de commande comprenant une première couche (10) d'émetteur d'un premier type de conductivité, une première couche (12) de base d'un deuxième type de conductivité formée sur la première couche (10) d'émetteur, une deuxième couche (14) de base du premier type de conductivité formée sur la première couche (12) de base, une pluralité de deuxièmes couches ($16_1$ à $16_n$) d'émetteur du deuxième type de conductivité formées sur la deuxième couche (14) de base, une pluralité de cathodes ($18_1$ à $18_n$) formées sur les deuxièmes couches ($16_1$ à $16_n$) d'èmetteur, une électrode de grille (20) disposée sur la deuxième couche (14) de base de manière à entourer les deuxièmes couches ($16_1$ à $16_n$) d'émetteur et les couches ($18_1$ à $18_n$) formant cathodes, et une anode (22) formée sur la première couche (10) d'émetteur du premier type de conductivité, caractérisé en ce que l'électrode de grille est constituée d'une pluralité d'électrodes séparées (40a, 40b, 40c, 40d) ayant sensiblement les mêmes surfaces, chacune de ces électrodes séparées (40a à 40d) entourant au moins l'une des deuxièmes couches ($16_1$ à $16_n$) d'émetteur et la cathode correspondante ($18_1$ à $18_n$).

2. Thyristor à grille de commande suivant la revendication 1, caractérisé en ce que la pluralité d'électrodes (40a à 40d) sont disposées symétriquement par rapport au centre de la deuxième couche (14) de base.

3. Thyristor à grille de commande suivant la revendication 2, caractérisé en ce que chacune de la pluralité d'électrodes séparées (40a à 40d) est en forme de secteur.

0  077  930

F I G. 1

F I G. 2

1

FIG. 3

FIG. 4

# F I G. 5

QG
[C]

A
B
C
D

I_A    (A)

# F I G. 6

t off

$I_A$ = CONSTANT

dQ_G/dt

## F I G. 7

## F I G. 8